# EUROPEAN PATENT APPLICATION

(11) **EP 2 984 965 A1**
(43) Date of publication of application: **17.02.2016**
(21) Application number: 14783127.5
(22) Date of filing: 04.04.2014
(51) Int. Cl.: A45C 11/24

(54) **PROTECTIVE JACKET OF ELECTRONIC PRODUCT**

(30) Priority: 07.04.2013 CN 201320167308 U
(71) Applicant: Century Star Assets Management Limited, Kowloon, Hong Kong 00 (CN)
(72) Inventor: ONDA, Hideki, Road Town Tortola 0000 (VG); TING, Siu Ming, Road Town Tortola 0000 (VG)
(74) Representative: Michalski Hüttermann & Partner Patentanwälte mbB
(86) International application number: PCT/CN2014/074784
(87) International publication number: WO 2014/166359

(57) **Abstract**

The present invention relates to a protective case for electronic device, which fixes on outer rim of a device for protection, and comprising a first frame fixing on the outer rim of the electronic device, a second frame fixing on the outer rim of the first frame; the hardness of the second frame is higher than the first frame. Comparing with the prior art, the protective case for electronic device provided in the present invention having a first frame and a second frame with different hardness, while the protective case being installed on the edge of the electronic device, it can easily be engaged on the device and hardly to fall off the device, thus to protect electronic device effectively.

## Description

### TECHNICAL FIELD

The present invention relates to a case for electronic device, and in particular, to a composite protective case for electronic device.

### DESCRIPTION OF THE RELATED ART

Some electronic devices such as smartphones or tablet PC are costly, and these devices are vulnerable to damage because of accidental crashing or dropping. Therefore, consumers typically attach a case on the outer rim of the electronic device to protect it from accidental damage.

However, some of the cases for electronic devices in the market are too stiff and poor of plasticity, it is difficult to install such case on the electronic device; some cases are easy to crack due to excessive forces during fixing the same into the devices; some other cases are too soft to tightly attach on the devices, due to the soften material provided, that the device may easily fall from the case. Therefore, consumers would need a better case for protecting their electronic devices.

### SUMMARY

The present invention is to provide a protective case for electronic device, which can easily be attached on the device and hardly to fall off, and with highly usability and convenience.

A protective case for electronic device, which fixes on outer rim of a device for protection, and comprising a first frame fixing on the outer rim of the electronic device, a second frame fixing on the outer rim of the first frame; the hardness of the second frame is higher than the first frame.

In some embodiments, the first frame having four sidewalls, each sidewall connects to another end-by-end, inner surface of the sidewalls are adjoining with the outer rim of the electronic device; outer surface of the sidewalls forming a continuous groove; and at least one portion of the second frame embedding into the groove to attach with the first frame.

In some embodiments, the second frame having four sidewalls, each sidewall connects to another end-by-end, these four sidewalls embedding into the groove of the first frame.

In some embodiments, a bulge is provided on one sidewall of the first frame that corresponding to a button of the electronic device; a button opening is also provided on one sidewall of the second frame that conesponding to the bulge on first frame, to facilitate the bulge for passing through thereof.

In some embodiments, a through-hole is provided on another sidewall of the first frame that corresponding to an interface of the electronic device; a through-hole is also provided on another sidewall of the second frame that corresponding to the interface of the electronic device.

In some embodiments, a side-slot is provided on still another sidewall of the first frame that corresponding to the button of the electronic device; a side-slot is also set on still another sidewall of the second frame that corresponding to the button of the electronic device.

In some embodiments, a volume button case is further provided between the first frame and the second frame, said volume button case having a base and two key presses, the key presses are provided on the base; the base is covered on the side-slot of the first frame; the two key presses passing through the side-slot of the second frame and extending out thereof.

In some embodiments, the thickness of the first frame is larger than the thickness of electronic device.

In some embodiments, the thickness of the second frame is equal to the thickness of electronic device.

In some embodiments, the material of the first frame is plastic, and the material of the second frame is metal; or, the material of the first frame is flexible plastic, and the material of the second frame is rigid plastic.

In some embodiments, a card holder is provided on a flat of the protective case, the flat is corresponding to the back side of the electronic device when the device is attached with the protective case; said card holder is formed by fixing a square protective piece on two or three sidewalls of the first frame or second frame.

In some embodiments, an adhesive layer is provided on the sidewalls that fixing with the protective piece, and the protective piece adhering on the adhesive layer.

In some embodiments, a restricted groove is provided on a fixed position of the protective piece that corresponding to the first frame or second frame; a restricted bulge is provided on the sidewall of the first frame or the second frame that corresponding to the restricted groove.

In some embodiments, a restricted bulge is provided on a fixed position of the protective piece that corresponding to the first frame or second frame; a restricted groove is provided on the sidewall of the first frame or the second frame that corresponding to the restricted bulge.

In some embodiments, a card holder is provided on a flat of the protective case, the flat is corresponding to the back side of the electronic device when the device is attached with the protective case; said card holder is formed by fixing a protective piece between the first frame and the second frame.

In some embodiments, two ends of the protective piece are adhered between the first frame and the second frame.

In some embodiments, a restricted bulge is provided on the protective piece where it is fixed on the first frame or second frame; a restricted groove is provided on the first frame or the second frame for receiving the restricted bulge.

In some embodiments, a restricted groove is provided on the protective piece where it is fixed on the first frame or second frame; a restricted bulge is provided on the first frame or the second frame for receiving the restricted groove.

In some embodiments, the protective piece is selected from the group consisting of cloth piece, leather piece, transparent plastic piece and opaque plastic piece.

Comparing with the prior art, the protective case for electronic device provided in the present invention having a first frame and a second frame with different hardness, while the protective case being installed on the edge of the electronic device, it can be easily to attach on the device and hardly to fall off the device, thus to protect electronic device effectively.

The protective case for electronic device can be applied to smart phones, tablet PC, portable music players and other electronic devices.

The following are detailed descriptions of the invention referencing embodiment and drawings.

### BRIEF DESCRIPTION OF THE DRAWINGS

FIG.1 is an assembling structural view of the protective case for electronic device according to one embodiment of the present invention;
FIG.2 is a perspective structural view of the first frame of the protective case in Fig. 1;
FIG.3 is a perspective structural view of the second frame of the protective case in Fig. 1;

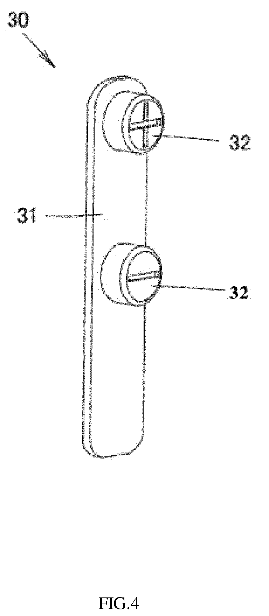

FIG.4 is a perspective structural view of the volume button case of the protective case in Fig. 1;
FIG.5 is a perspective structural view of protective case for electronic device according to another embodiment of the present invention;
FIG.6 to FIG.10 are structural views showing five different ways of installation of the protective piece.

**Description of element symbols**

| | |
|---|---|
| electronic device | 01 |
| first frame | 10 |
| sidewall | 11, 12, 13, 14, 21, 22, 23, 24 |
| bulge | 110 |
| through-hole | 130, 230 |
| side-slot | 140, 240 |
| groove | 15 |
| second frame | 20 |
| button opening | 210 |
| volume button case | 30 |
| base | 31 |
| button | 32 |
| protective piece | 33 |

### DETAILED DESCRIPTION OF PREFERRED EMBODIMENTS

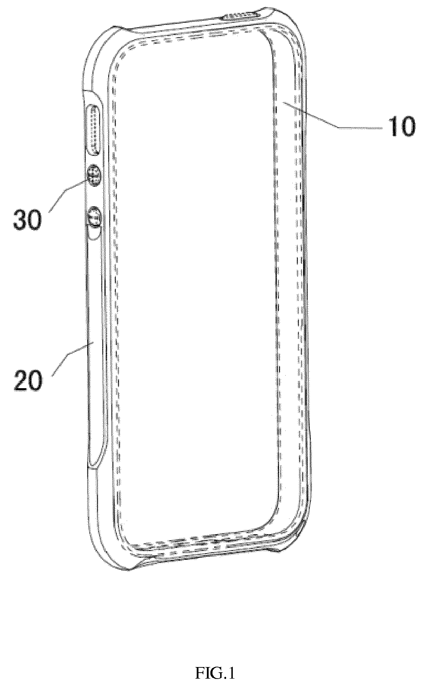

As shown in Fig.1, a protective case for electronic device in this embodiment includes a first frame 10, a second frame 20 engaging with the first frame 10, a volume button case 30 clamps between the first frame 10 and the second frame 20. In the drawing, exposed contour lines of the first frame 10 and the volume button case 30 are presented by broken lines, in order to display the position relationship between the first frame 10, the second frame 20 and volume button case 30 more clearly.

The protective case for electronic device is fixed on the outer rim of an electronic device (not shown in Figs) to avoid or to reduce the damage caused by accidental crashing or dropping, the protective case can be applied to protect smart phones, tablet PC, portable music players and other electronic devices.

The first frame 10 of the protective case for electronic device fixes on the outer rim of the electronic device, and the second frame 20 attaches on the outer rim of the first frame 10, hardness of the second frame 20 is higher than the first frame 10 therein. For example, the material of first frame 10 is plastic, and the material of second frame 20 is metal; or the material of first frame 10 is flexible plastic, and the material of second frame 20 is rigid plastic. There's no special requirement for the scale of hardness, as long as the hardness of the flexible plastic is less than the rigid plastic. While the hardness of the first frame 10 is less, it has larger plastic deformation than the second frame 20, thus it is easier for the first frame to attach on the outer rim of the electronic device. Also, it is easier for the second frame 20 to engage on the outer rim of the first frame 10 in virtue of the larger plastic deformation of the first frame 10, meanwhile, once the second frame 20 attached on the first frame 10, the first frame 10 is difficult to deform due to the restriction of the second frame 20, thus to prevent the falling of the first frame 10 and the second frame 20 from the electronic device, to protect the device effectively.

The present invention will now be described more specifically with reference to the following embodiments; the electronic device hereafter is exampled by a smart phone. It should be noted that the following descriptions of preferred embodiments of this invention are presented herein for purpose of illustration and description only. It is not intended to be exhaustive or to be limited to the precise form disclosed.

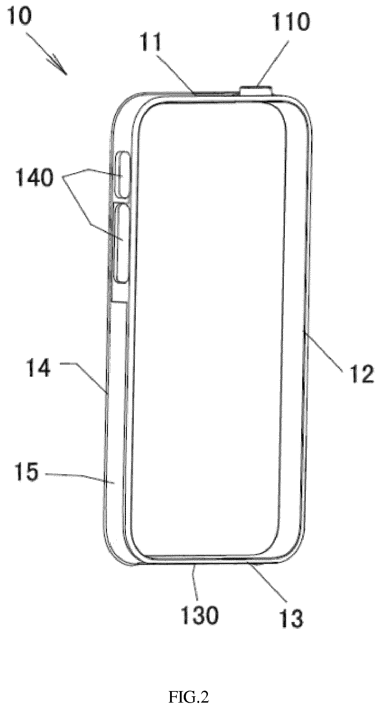

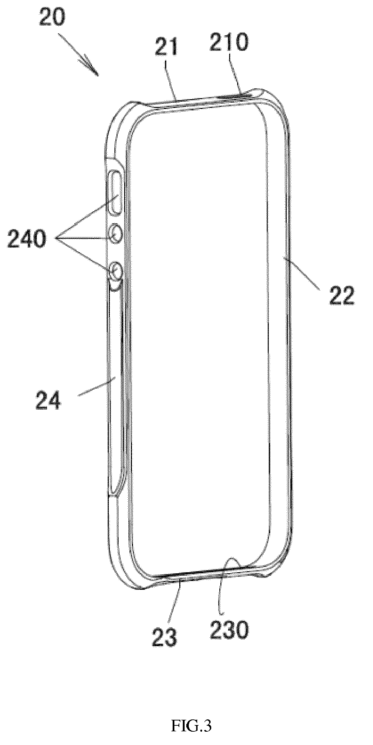

As shown in FIG.1, 2 and 3, the first frame 10 having four sidewalls 11,12,13,14, each sidewall connects to another end-by-end, inner surface of the sidewalls 11,12,13,14 are adjoining with the outer rim of the smart phone; outer surface of the sidewalls 11,12,13,14 forming a continuous groove 15; and at least one portion of the second frame 20 embedding into the groove 15 thus to engage with the first frame 10.

In addition, a bulge 110 is provided on the sidewall 11 of the first frame 10 that corresponding to a button, such as power switch, of the electronic device. The bulge 110 is used for protecting the button and preventing from being attrition due to multiple repeating usage.

A through-hole 130 is provided on another sidewall 13 of the first frame 10 that corresponding to an interface of the electronic device, such as a USB interface and/or a headphone port, and the interface is exposed to outside by the through-hole 130.

A side-slot 140 is provided on still another sidewall 14 of the first frame 10 corresponding to the button of the electronic device, such as lock button and/or volume button, and the button is exposed to outside by the side-slot 140 for using the device conveniently.

The second frame 20 having four sidewalls 21,22,23,24, each sidewall connects to another end-by-end, the four sidewalls 21,22,23,24 of the second frame 20 embedding into the groove 15 of the first frame 10, thus to engage the second frame 20 with the first frame10.

A button opening 210 is provided on the sidewall 21 of the second frame 20 that conesponding to the bulge 110 of the first frame 10, for the bulge 110 to pass through thereof.

A through-hole 230 is provided on another sidewall 23 of the second frame 20 that corresponding to the through-hole 130 of the first frame 10, for the interface of electronic device to expose outside thereof.

A side-slot 240 that corresponding to the side-slot 140 of the first frame 10 is also provided on the sidewall 24 of the second frame 20, the side-slot 240 is corresponding to the lock button and/or volume button of the electronic device.

A volume button case 30 is further provided between the first frame 10 and the second frame 20, for better protecting the volume button. The volume button case 30 having a base 31 and two key presses 32, the key presses 32 are provided on the base 31; the base 31 is covered on the side-slot 140 of the first frame 10; the two key presses 32 passing through the side-slot 240 of the second frame 20 and extending out thereof.

Furthermore, the thickness of the first frame 10 is larger than the thickness of the smart phone, while installed, the edge of the four sidewalls 11,12,13,14 of the first frame 10 protrude from the screen surface and bottom cover of the smart phone, thus, while the smart phone is put on a table or other platform, it is the edge of the four sidewalls 11,12,13,14 directly touching with the table, thus to protect the screen and bottom cover of smart phone and avoid being attrition.

The thickness of the second frame 20 is less than the thickness of the first frame 10, and particularly, the thickness of the second frame 20 is the thickness of groove 15 of the first frame 10, and also is equal to or almost equal to the thickness of the smart phone.

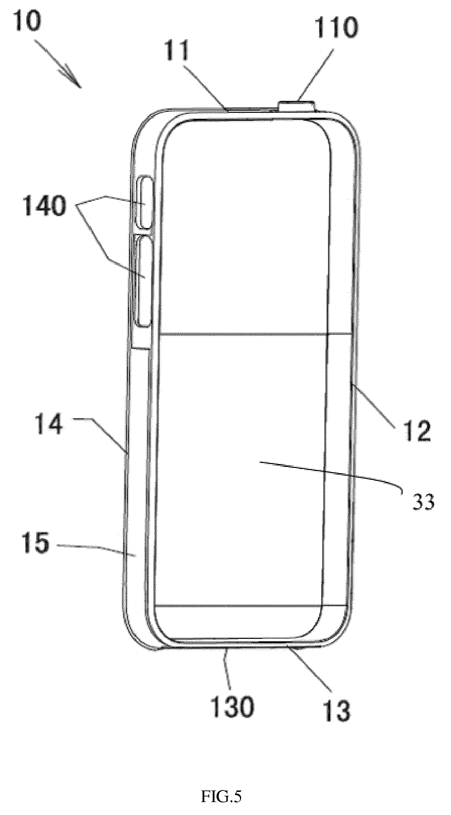

As shown in FIG.5, comparing to the embodiment shown in FIG.1, the present invention provides another embodiment that, a card holder is provided on a flat of the protective case, the flat is conesponding to the back side of the electronic device when the device is attached with the protective case; said card holder is formed by attaching a square protective piece 33 on two or three sidewalls of the first frame 10 or the second frame 20. And the protective piece 33 could be a cloth piece, a leather piece, a transparent plastic piece or an opaque plastic piece; and the thickness of the card holder is about 1mm.

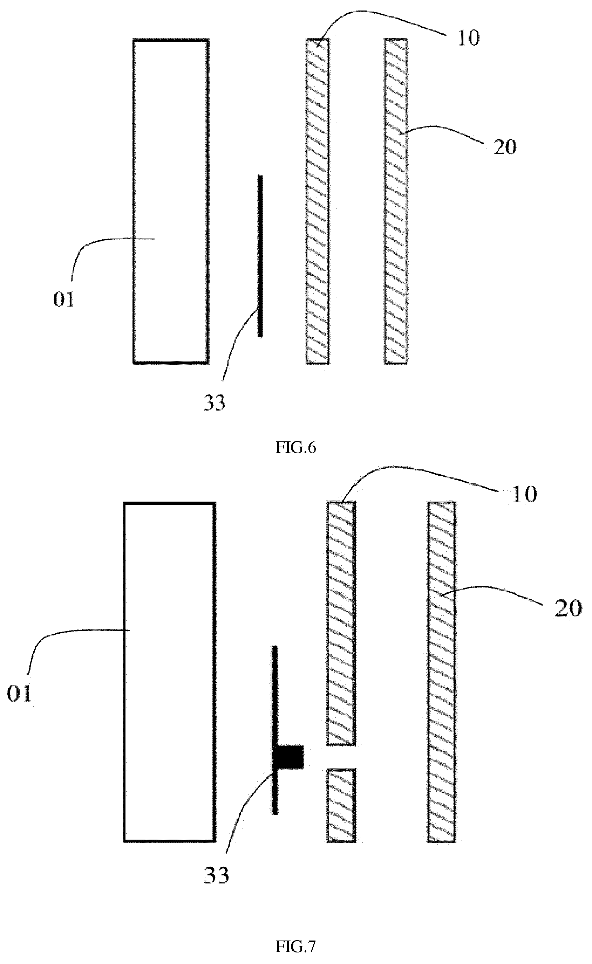

As shown in FIG.6, edges of the protective piece 33 are fixed between the first frame 10 and the electronic device 01, an adhesive layer is provided on the sidewalls of the first frame 10, and two ends of the protective piece 33 adhering on the adhesive layer.

As shown in FIG.7, edges of the protective piece 33 are fixed between the first frame 10 and the electronic device 01; a first restricted groove is provided on the ends of protective piece 33, such ends fixed on the first frame 10; accordingly, a first restricted bulge is provided on the sidewall of the first frame 10 for receiving the first restricted groove.

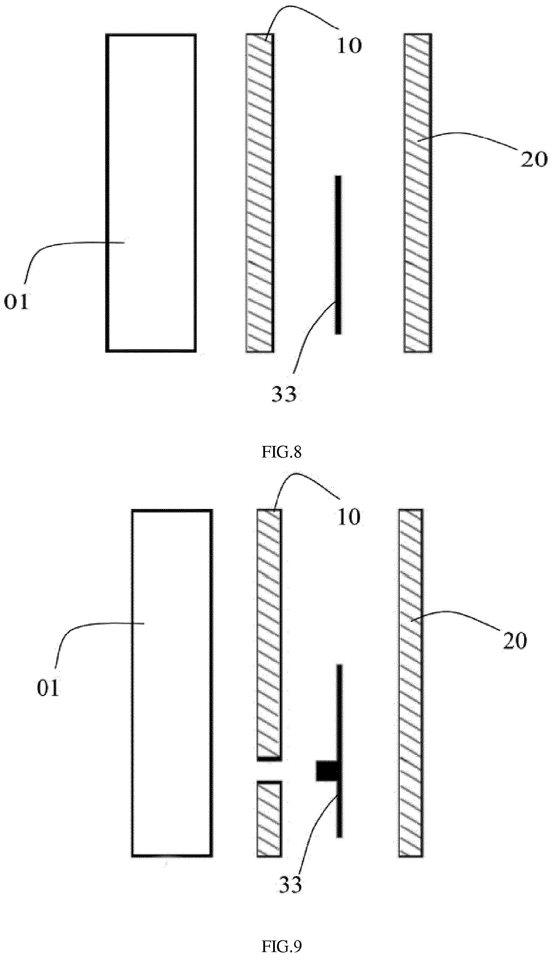

As shown in FIG.8, edges of the protective piece 33 are fixed between the first frame 10 and the second frame 20; ends of protective piece 33 are adhering between the first frame 10 and the second frame 20.

As shown in FIG.9, edges of the protective piece 33 are fixed between the first frame 10 and the second frame 20; a second restricted groove is provided on the ends of protective piece 33, such ends fixed on the first frame 10; accordingly, a second restricted bulge is provided on the sidewall of the first frame 10 for receiving the second restricted groove.

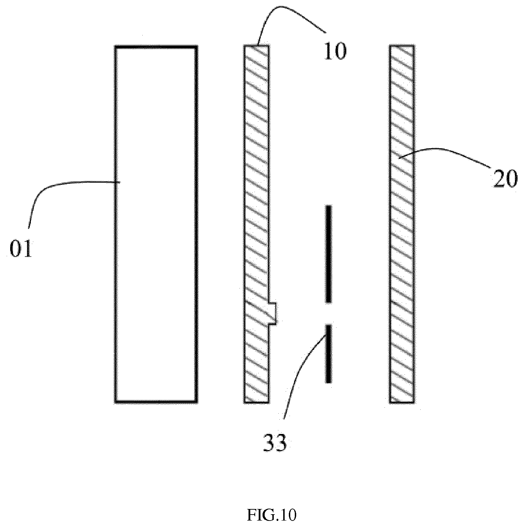

As shown in FIG.10, edges of the protective piece 33 are fixed between the first frame 10 and the second frame 20; a third restricted groove is provided on the ends of protective piece 33, such ends fixed on the first frame10; accordingly, a third restricted bulge is provided on the sidewall of the first frame 10 for receiving the third restricted groove.

Ends of the protective piece 33 are adhering on the adhesive layer of the first frame 10, or, be clamping between the first frame 10 and the second frame 20. While the thickness of the card holder is about 1mm, the protective piece 33 could be a cloth piece, a leather piece, a transparent plastic piece or an opaque plastic piece.

While the invention has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. A protective case for electronic device, fixes on outer rim of a device for protection, comprising
a first frame fixing on the outer rim of the electronic device,
a second frame fixing on the outer rim of the first frame;
wherein, the hardness of the second frame is higher than the first frame.

2. The protective case for electronic device as in claim 1, wherein the first frame having four sidewalls, each sidewall connects to another end-by-end, inner surface of the sidewalls are adjoining with the outer rim of the electronic device; outer surface of the sidewalls forming a continuous groove; and at least one portion of the second frame embedding into the groove to engage with the first frame.

3. The protective case for electronic device as in claim 2, wherein the second frame having four sidewalls, each sidewall connects to another end-by-end, these four sidewalls embedding into the groove of the first frame.

4. The protective case for electronic device as in claim 3, wherein a bulge is provided on one sidewall of the first frame that corresponding to a button of the electronic device; a button opening is also provided on one sidewall of the second frame that corresponding to the bulge on the first frame, to facilitate the bulge for passing through thereof.

5. The protective case for electronic device as in claim 3, wherein a through-hole is provided on another sidewall of the first frame that corresponding to an interface of the electronic device; a through-hole is also provided on the other sidewall of the second frame that corresponding to the interface of the electronic device.

6. The protective case for electronic device as in claim 3, wherein a side-slot is provided on the other sidewall of the first frame that corresponding to the button of the electronic device; a side-slot is also set on the other sidewall of the second frame that corresponding to the button of the electronic device.

7. The protective case for electronic device as in claim 6, wherein a volume button case is further provided between the first frame and the second frame, said volume button case having a base and two key presses, the key presses are provided on the base; the base is covered on the side-slot of the first frame; the two key presses passing through the side-slot of the second frame and extending out thereof.

8. The protective case for electronic device as in claim 3, wherein the thickness of the first frame is larger than the thickness of electronic device.

9. The protective case for electronic device as in claim 8, wherein the thickness of the second frame is equal to the thickness of electronic device.

10. The protective case for electronic device as in claim 1-9, wherein the material of the first frame is plastic, and the material of the second frame is metal; or, the material of the first frame is flexible plastic, and the material of the second frame is rigid plastic.

11. The protective case for electronic device as in claim 10, wherein a card holder is provided on a flat of the protective case, the flat is corresponding to the back side of the electronic device when the device is attached with the protective case; said card holder is formed by attaching a square protective piece on two or three sidewalls of the first frame or second frame.

12. The protective case for electronic device as in claim 11, wherein an adhesive layer is provided on the sidewalls that fixing with the protective piece, and the protective piece adhering on the adhesive layer.

13. The protective case for electronic device as in claim 11, wherein a restricted groove is provided on a fixed position of the protective piece that corresponding to the first frame or second frame; a restricted bulge is provided on the sidewall of the first frame or the second frame that corresponding to the restricted groove.

14. The protective case for electronic device as in claim 11, wherein a restricted bulge is provided on a fixed position of the protective piece that corresponding to the first frame or second frame; a restricted groove is provided on the sidewall of the first frame or the second frame that corresponding to the restricted bulge.

15. The protective case for electronic device as in claim 11-14, wherein the protective piece is selected from the group consisting of cloth piece, leather piece, transparent plastic piece and opaque plastic piece.

16. The protective case for electronic device as in claim 10, wherein a card holder is provided on a flat of the protective case, the flat is corresponding to the back side of the electronic device when the device is attached with the protective case; said card holder is formed by attaching a protective piece between the first frame and the second frame.

17. The protective case for electronic device as in claim 16, wherein two ends of the protective piece are adhered between the first frame and the second frame.

18. The protective case for electronic device as in claim 16, wherein a restricted bulge is provided on the protective piece where it is fixed on the first frame or second frame; a restricted groove is provided on the first frame or the second frame for receiving the restricted bulge.

19. The protective case for electronic device as in claim 16, wherein a restricted groove is provided on the protective piece where it is fixed on the first frame or second frame; a restricted bulge is provided on the first frame or the second frame for receiving the restricted groove.

20. The protective case for electronic device as in claim 16-19, wherein the protective piece is selected from the group consisting of cloth piece, leather piece, transparent plastic piece and opaque plastic piece.
